Europäisches Patentamt

European Patent Office

Office européen des brevets

(11) Publication number: **0 450 468 A1**

# EUROPEAN PATENT APPLICATION

(21) Application number: 91104769.4

(22) Date of filing: 26.03.91

(51) Int. Cl.5: **H01L 27/142**, H01L 31/0392, H01L 31/0224

(30) Priority: 30.03.90 JP 84554/90

(43) Date of publication of application:
09.10.91 Bulletin 91/41

(84) Designated Contracting States:
DE ES FR GB IT

(71) Applicant: **Showa Shell Sekiyu Kabushiki Kaisha**
**2-5, Kasumigaseki 3-chome Chiyoda-ku Tokyo(JP)**

(72) Inventor: **Sichanugrist, Porponth**
**c/o Showa Shell Sekiyu K.K., 3-2-5, Kasumigaseki**
**Chiyoda-ku, Tokyo(JP)**
Inventor: **Tanaka, Norimitsu**
**c/o Showa Shell Sekiyu K.K., 3-2-5, Kasumigaseki**
**Chiyoda-ku, Tokyo(JP)**

(74) Representative: **Hansen, Bernd, Dr.**
**Dipl.-Chem. et al**
**Hoffmann, Eitle & Partner Patent- und Rechtsanwälte Arabellastrasse 4 Postfach 81 04 20**
**W-8000 München 81(DE)**

(54) Photovoltaic device and process for manufacturing the same.

(57) A photovoltaic device and a process for manufacturing a photovoltaic device are described. The photovoltaic device includes an insulating transparent substrate plate, a thin metal film provided thereon as a front surface electrode, an amorphous semiconductor layer provided on the front electrode, and a back electrode provided on the amorphous semiconductor layer. The process for manufacturing a photovoltaic device includes the steps of depositing a plurality of thin film metal electrodes apart from each other on an insulating transparent substrate plate, forming an amorphous semiconductor layer over the thin film metal electrodes, and then forming patterned back electrodes, such that each back electrode is opposite to a thin film metal electrode.

FIG. 6

FIELD OF THE INVENTION

The present invention relates to a photovoltaic device for use as a solar cell, photosensor, or the like, and more particularly, to a thin-film photovoltaic device having a plurality of photovoltaic regions connected in series. The present invention also relates to a process for manufacturing the photovoltaic device.

BACKGROUND OF THE INVENTION

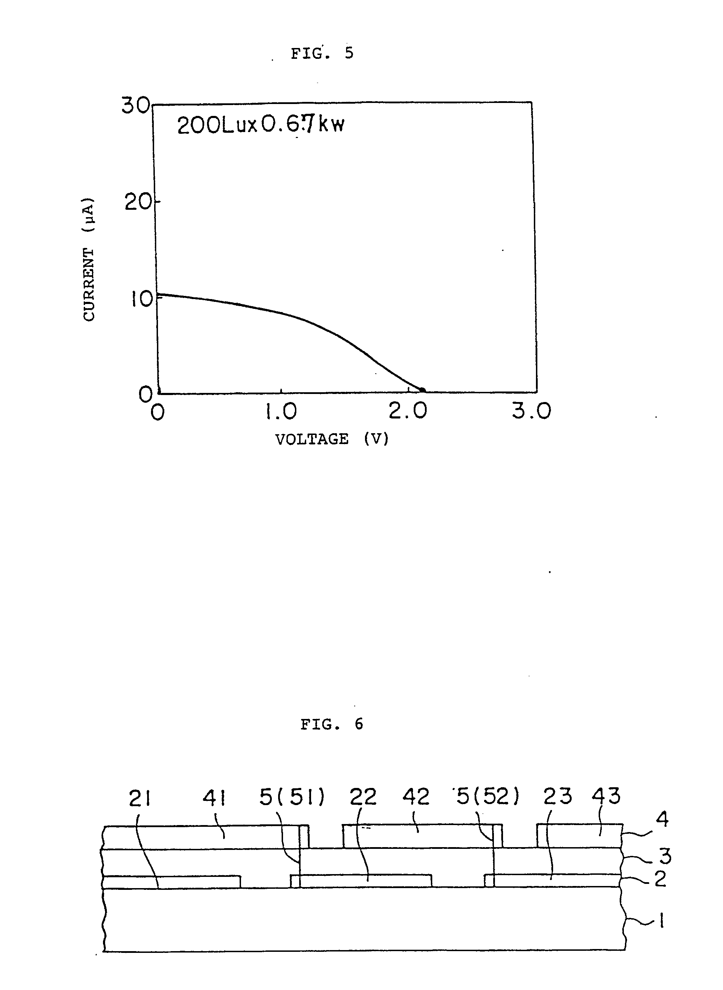

As Fig. 6 shows, amorphous silicon solar cells have a construction in which unit solar cell elements are connected electrically in series on an insulating substrate plate, each unit solar cell element comprising a transparent electrode layer, an amorphous silicon (hereinafter referred to as a-Si) layer as an amorphous semiconductor layer, and a metal electrode layer or conductive printed electrode layer as a back electrode layer, superposed in this order. Illustratively stated, this a-Si solar cell comprises a single glass substrate plate 1 and, superposed thereon, transparent electrodes 2 (21-23), an a-Si layer 3, and back electrodes 4 (41-43), thus forming a plurality of unit solar cell elements. These unit solar cell elements are arranged in series by connecting the back electrode in each element to the transparent electrode in an adjacent element with a conductive path 5 (51, 52).

In manufacturing this kind of solar cell, a transparent conductive film, such as an ITO (indium tin oxide) or SnO₂ (tin oxide) film or the like, is first formed over a glass substrate plate 1 at a thickness of about 800 Å by electron beam vapor deposition, sputtering, or a thermal CVD process. A transparent electrode layer 2 is then formed by patterning the transparent conductive film with a laser beam, a photolithographic technique, or other technique.

An a-Si layer 3 is then deposited on the transparent electrode layer 2 by the plasma discharge decomposition of silane gases. For example, a p-type a-Si layer is deposited at a thickness of about 200 Å, an undoped a-Si layer at 0.2-1.0 μm, and an n-type a-Si layer at about 500 Å. The p-type a-Si is obtained by doping boron and carbon, while the n-type a-Si is obtained by doping phosphorus.

Then, a patterned back electrode layer is deposited on the a-Si layer. The back electrodes are metal electrodes or conductive printed electrodes.

Subsequently, a conductive path 5 is formed by partly heating and melting the transparent electrode 2 and the a-Si layer 3 in a photovoltaic region and partly heating and melting the back electrode 4 in an adjacent photovoltaic region by irradiation with a laser beam, thereby connecting the transparent electrode 2 in the photovoltaic region with with the back electrode 4 in the adjacent photovoltaic region. Thus, an a-Si solar cell in which unit solar cell elements are connected electrically in series can be manufactured.

Besides the above-described technique for connecting unit solar cell elements, other connecting techniques are used, such as that described, for example, in JP-A-57-12568 and JP-A-59-35489. (The term "JP-A" as used herein means an "unexamined published Japanese patent application".) In this conventional method, a patterned back electrode layer is formed after an a-Si layer 3 is first deposited and then perforated or partly turned into microcrystalline silicon by laser processing. As a result, the back electrode is in contact with the surface electrode through the perforations or the microcrystalline silicon.

The above-described conventional methods are disadvantageous because of the use of tin oxide or ITO, which are expensive, as the transparent electrode. That is, it is difficult to reduce raw material costs. Further, deposition of tin oxide or ITO by a thermal CVD process or sputtering necessitates heating the substrate plate. Moreover, oxide targets are expensive, and with sputtering it is necessary to use a complex apparatus (for example, an alternating-current magnetron sputtering apparatus).

SUMMARY OF THE INVENTION

Accordingly, an object of the present invention is to provide a photovoltaic device having a front electrode that is made of an inexpensive material as a substitute for tin oxide or ITO and can be formed easily in large quantity.

Another object of the present invention is to provide a process for manufacturing the above photovoltaic device.

The objects of the present invention are accomplished with a photovoltaic device comprising an insulating transparent substrate plate, a thin metal film provided thereon as a front electrode, an amorphous semiconductor layer provided on the front electrode, and a back electrode provided on the amorphous semiconductor layer and a process for manufacturing a photovoltaic device, the process comprising depositing a plurality of thin film metal electrodes apart from each other on an insulating transparent substrate plate, forming an amorphous semiconductor layer over the thin film metal electrodes, and then forming patterned back electrodes, such that each back electrode is opposite to a thin film metal electrode.

BRIEF DESCRIPTION OF THE DRAWINGS

Figs. 1(a) to 1(d) are sectional views illustrating a process for manufacturing a photovoltaic device according to the present invention;

Fig. 2 is a graph showing the light transmission properties of thin metal films;

Figs. 3(a) and 3(b) are graphs showing the current-voltage properties at 200 lux of a thin film metal electrode-type solar cell employing an Ni film as a front electrode;

Figs. 4(a) and 4(b) are graphs showing the current-voltage properties at 1,000 lux of a thin film metal electrode-type solar cell employing an Ni film as a front electrode;

Fig. 5 is a graph showing the current-voltage properties at 200 lux of a thin film metal electrode-type solar cell employing an Al film as a front electrode; and

Fig. 6 is a sectional view illustrating the construction of a conventional photovoltaic device.

DETAILED DESCRIPTION OF THE INVENTION

As noted above, the objects of the present invention are accomplished with a photovoltaic device comprising an insulating transparent substrate plate, a thin metal film provided thereon as a front electrode, an amorphous semiconductor layer provided on the front electrode, and a back electrode provided on the amorphous semiconductor layer, and a process for the manufacture thereof.

In a preferred embodiment of the photovoltaic device of the present invention, the front electrode has been divided into a plurality of regions to form a plurality of unit solar cells corresponding to the regions.

In another preferred embodiment, the back electrode in a unit solar cell has an electrode portion overlapping part of a front electrode in an adjacent unit solar cell, and an electrical connection between the back electrode and the adjacent front electrode has been made at this overlap.

In still another preferred embodiment, the thin metal film is made of aluminum or nickel.

The photovoltaic device manufacturing process of the present invention comprises depositing a plurality of thin film metal electrodes apart from each other on an insulating transparent substrate plate, forming an amorphous semiconductor layer over the thin film metal electrodes, and then forming patterned back electrodes opposite to each of the thin film metal electrodes.

The manufacturing process of the present invention can further comprise forming an electrical connection between a back electrode in a unit cell and a thin film metal electrode in an adjacent unit cell.

The use of a thin metal film as a front electrode is advantageous in that the front electrode can be deposited by using an inexpensive metal target and a simple sputtering apparatus without the necessity of heating the substrate plate. Accordingly, material costs can be reduced.

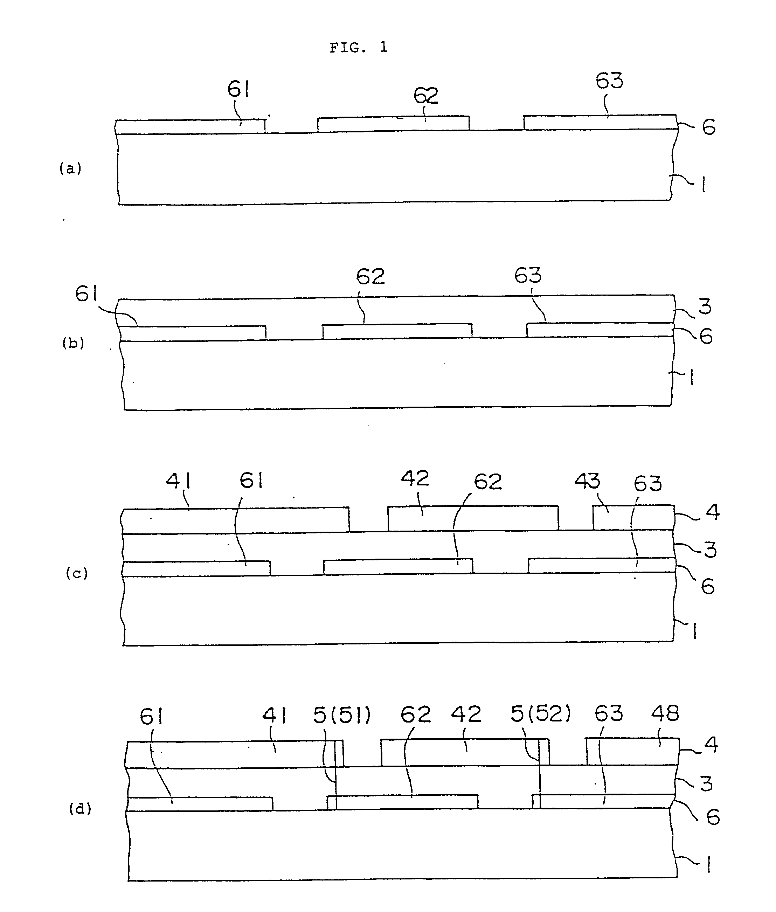

Embodiments of the present invention are explained below with reference to the accompanying drawings. Fig. 1(a) to 1(d) are sectional views illustrating an example of the process of this invention for manufacturing an amorphous silicon solar cell. Fig. 1(d) shows the construction of one example of the photovoltaic device of this invention. In Figs. 1(a)-1(d) and 6, like portions or parts are designated by like numerals.

As shown in Fig. 1(a), a thin Al or Ni film having a thickness of 100 Å or less is first deposited on a glass substrate plate 1 by a direct-current sputtering process, thereby forming a thin film metal electrode 6. For example, this sputtering may be effected under an argon pressure of 5 Torr and a power of 0.17 to 0.65 kW. Thereafter, the thin metal film is processed with a YAG laser beam having a wavelength of 1.06 $\mu$m to form a plurality of front electrodes 6 (61-63).

As illustrated in Fig. 1(b), an a-Si film 3 having a p-i-n junction is subsequently formed at a thickness of about 0.8 $\mu$m by a plasma CVD process.

As shown in Fig. 1(c), patterned metallic back electrodes or conductive printed back electrodes 4 (41-43) are then formed. Each of these back electrodes 4 is formed so that it partly overlaps an adjacent conductive metal electrode 6 through the a-Si film.

An electrical connection between unit solar cell elements is established at the portion where a back electrode partly overlaps an adjacent conductive metal electrode. That is, as shown in Fig. 1(d), when this overlapped portion of each photovoltaic region is irradiated from the glass substrate plate side, with a laser beam having a wavelength of 1.06 $\mu$m, the irradiated portion of the thin film metal electrode 6 and the a-Si film 3 in each photovoltaic region are heated and melted along with the irradiated portion of the back electrode 4 in the adjacent photovoltaic region to form an alloy 5, which constitutes conductive paths 51 and 52. These conductive paths 51 and 52 connect the back electrodes 41 and 42 with the thin film metal electrodes 62 and 63, respectively. Thus, an a-Si solar cell is manufactured with unit solar cell elements electrically connected in series.

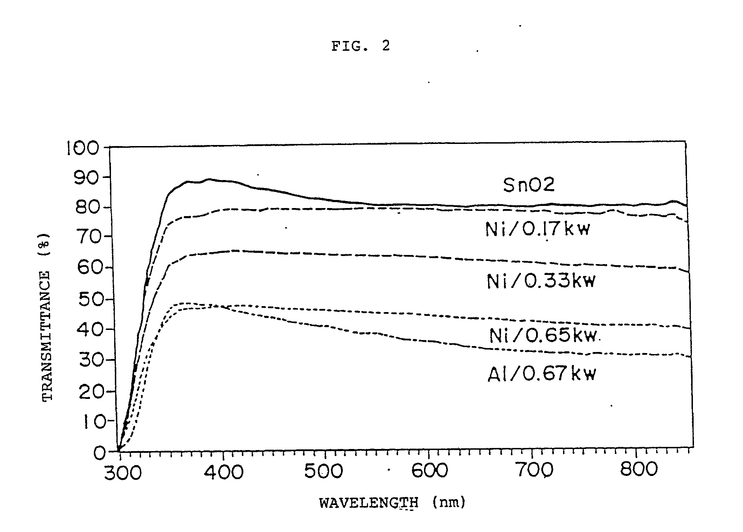

In Fig. 2, a thin Al film and thin Ni films are compared with a tin oxide ($SnO_2$) film in regard to light transmittance. Fig. 2 shows the relationship between wavelength and the transmittance of each of the $SnO_2$, Al, and Ni thin films.

The Al film was formed at a sputtering power of 0.67 kW, while the Ni films were formed at sputtering powers of 0.65, 0.33, and 0.17 kW, respectively. In general, as the sputtering power used in forming these metal films becomes lower, the film thickness tends to decrease and the transmittance tends to increase. The Ni film formed at 0.17 kW shows substantially the same transmission properties as those of the $SnO_2$ film (800 Å in thickness). The Al film formed at the above sputtering power had a thickness of about 80 Å, while the Ni films formed at the above sputtering powers had thicknesses of about 80 Å, 40-50 Å, and about 20 Å, respectively.

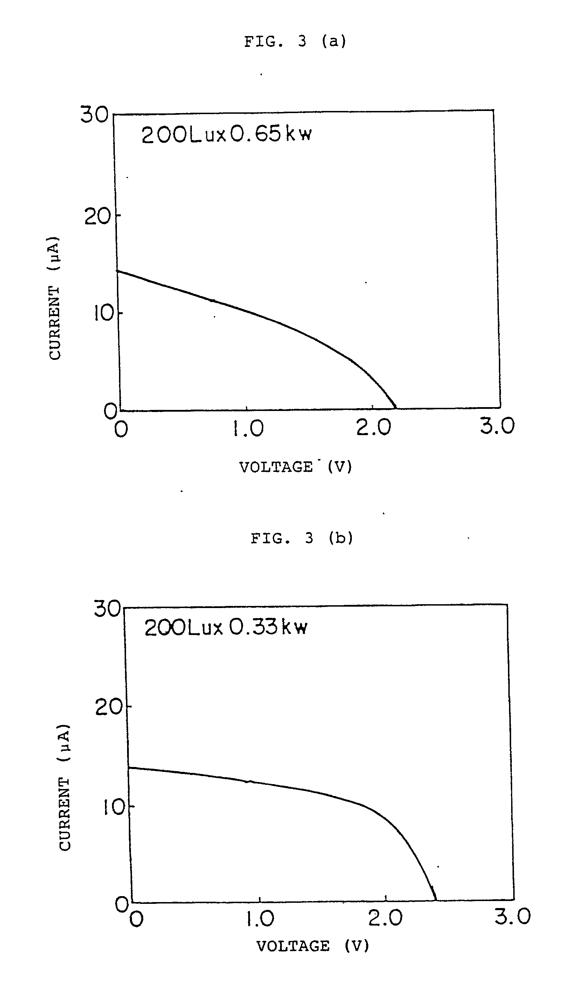

Figs. 3(a) and 3(b) show the current-voltage properties at 200 lux of thin film metal electrode-type solar cells employing an Ni film as a front electrode. The current-voltage properties shown in Fig. 3(a) are for a solar cell in which the Ni layer was formed at a sputtering power of 0.65 kW, while those shown in Fig. 3(b) are for a solar cell in which the Ni layer was formed at a sputtering power of 0.33 kW.

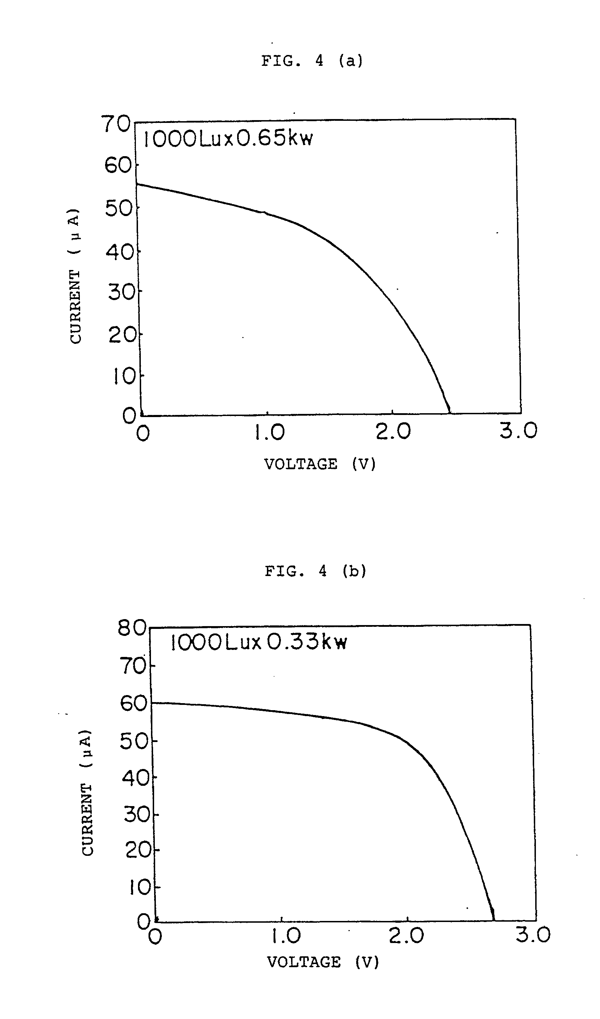

Figs. 4(a) and 4(b) show the current-voltage properties of the same solar cells at 1,000 lux.

From the current-voltage properties of the solar cells employing an Ni film, the following results were found. At 200 lux, the solar cell employing a thinner Ni film was less apt to suffer shunting between electrodes and showed an improved conversion efficiency of 4.7% (as compared to 3.0% for the solar cell employing a thicker Ni film). At 1,000 lux, the solar cell employing a thinner Ni film was less apt to suffer shunting and showed an even more improved conversion efficiency of 5.2%.

Fig. 5 shows the current-voltage properties at 200 lux of a solar cell employing an Al film formed at a sputtering power of 0.67 kW. The conversion efficiency of this solar cell was as low as 2.3% because of a poor fill factor and low current. These detrimental conditions resulted from oxidation which deteriorated interfacial properties of the Al film.

Table 1 summarizes characteristics of chips having the above-described current-voltage properties.

## Table 1

| | | Ni | | | Al |
|---|---|---|---|---|---|
| Film thickness (Å) | 80 | 40-50 | 80 | 40-50 | 80 |
| Chip Area (cm²) | 0.77 | 0.74 | 0.77 | 0.74 | 0.77 |
| Illuminance (lux) | 200 | 200 | 1000 | 1000 | 200 |
| Maximum Power (μw) | 11.689 | 17.903 | 62.328 | 98.515 | 9.009 |
| Optimum Operating Current (μA) | 8.09 | 9.73 | 39.20 | 48.77 | 7.09 |
| Optimum Operating Voltage (V) | 1.41 | 1.84 | 1.59 | 2.02 | 1.27 |
| Short Circuit Current (μA) | 14.29 | 13.96 | 55.74 | 59.76 | 10.51 |
| Open Circuit Voltage (V) | 2.22 | 2.40 | 2.44 | 2.70 | 2.20 |
| Short Circuit Current Density (μA/cm²) | 18.55 | 18.86 | 72.39 | 80.76 | 13.65 |
| Optimum Operating Current Density (μA/cm²) | 10.77 | 13.15 | 50.91 | 65.91 | 9.21 |
| Fill Factor | 0.369 | 0.535 | 0.458 | 0.612 | 0.390 |
| Conversion Efficiency (%) | 3.0 | 4.7 | 3.2 | 5.2 | 2.3 |

All of the experimentally manufactured chips shown in Table 1 were ascertained to be sufficient to drive a desk calculator, which requires a voltage of 1.2 V and a current of 2 $\mu$A.

As described above, the photovoltaic device of the present invention is advantageous because the use of a thin metal film as the front electrode eliminates the necessity of heating the substrate plate to form a front electrode. Also, a sputtering apparatus having a simple construction can be used. At the same time, the photovoltaic device is suited for mass production because the front electrode can be formed by the direct-current magnetron sputtering process. Furthermore, the production cost of the front electrode can be reduced, since the electrode is formed by the use of a low-cost metal target.

While the invention has been described in detail and with reference to specific embodiments thereof, it will be apparent to one skilled in the art that various changes and modifications can be made therein without departing from the spirit and scope thereof.

## Claims

1. A photovoltaic device comprising an insulating transparent substrate plate, a thin metal film provided thereon as a front electrode, an amorphous semiconductor layer provided on the front electrode, and a back electrode provided on the amorphous semiconductor layer.

2. A photovoltaic device according to claim 1, wherein the front electrode has been divided into a plurality of regions to form a plurality of unit solar cells corresponding to the regions.

3. A photovoltaic device according to claim 2, wherein the back electrode opposite to the front electrode in each unit solar cell has an electrode portion overlapping part of a front electrode adjacent to said front electrode, and an electrical connection between said back electrode and said adjacent front electrode has been made at said overlap.

4. A photovoltaic device according to claim 1, wherein the thin metal film is made of aluminum or nickel.

5. A process for manufacturing a photovoltaic device, the process comprising depositing a plurality of thin film metal electrodes apart from each other on an insulating transparent substrate plate, forming an amorphous semiconductor layer over the thin film metal electrodes, and then forming patterned back electrodes, such that each back electrode is opposite to a thin-film metal electrode.

6. A process according to claim 5, wherein the process further comprises forming an electrical connection between a back electrode in a unit cell and a thin film metal electrode in an adjacent unit cell.

7. A process according to claim 5, wherein the thin film metal electrodes comprise aluminum or nickel.

FIG. 1

(a)

(b)

(c)

(d)

FIG. 2

FIG. 3 (a)

FIG. 3 (b)

FIG. 4 (a)

1000Lux0.65kw

FIG. 4 (b)

1000Lux0.33kw

10

FIG. 5

FIG. 6

European
Patent Office

**EUROPEAN SEARCH REPORT**

Application Number

**EP 91 10 4769**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 023 929 (SIEMENS AG) <br> * Page 1, lines 20-35; page 2, line 117 - page 3, line 3; page 3, lines 44-46; figure 1 * | 1,2,4 | H 01 L 27/142 <br> H 01 L 31/0392 <br> H 01 L 31/0224 |
| Y | | 3,5-7 | |
| Y | US-A-4 428 110 (J.K. KIM) <br> * Column 1, line 54 - column 2, line 36; figure 1 * | 3,5-7 | |
| X | | 1,2 | |
| X | EP-A-0 193 820 (KANEGAFUCHI KAGAKU KOGYO K.K.) <br> * Column 3, lines 7-20; column 4, line 38 - column 5, line 29 * | 1,2,4 | |
| A | | 3,5-7 | |
| A | US-A-4 581 620 (S. YAMAZAKI et al.) <br> * Column 2, line 65 - column 3, line 34; column 7, line 41 - column 8, line 17; figure 1 * | 1,2,3,5,6 | |
| A | EP-A-0 340 412 (KANEGAFUCHI CHEMICAL IND. CO., LTD) <br> * Column 7, line 15 - column 8, line 15; column 9, lines 25-39; figure 1 * | 1,4 | TECHNICAL FIELDS SEARCHED (Int. Cl.5) <br><br> H 01 L |

The present search report has been drawn up for all claims

| Place of search | Date of completion of search | Examiner |
|---|---|---|
| The Hague | 12 July 91 | DE LAERE A.L.C. |